# EUROPÄISCHE PATENTANMELDUNG

(11) **EP 0 895 278 A2**
(43) Veröffentlichungstag der Anmeldung: **03.02.1999**
(21) Anmeldenummer: 98112890.3
(22) Anmeldetag: 10.07.1998
(51) Int. Cl.: H01L 21/033

(54) **Strukturierungsverfahren**

(30) Priorität: 01.08.1997 DE 19733345
(71) Anmelder: SIEMENS AKTIENGESELLSCHAFT, 80333 München (DE)
(72) Erfinder: Engelhardt, Manfred, Dr., 83620 Feldkirchen-Westerham (DE); Weinrich, Volker, Dr., 81549 München (DE)

(57) **Zusammenfassung**

Erfindungsgemäß wird ein Verfahren zur Strukturierung zumindest einer zu strukturierenden Schicht, bereitgestellt, das die folgenden Schritte umfaßt: auf die zu strukturierende Schicht wird eine Opferschicht aufgebracht, auf die Opferschicht wird eine Maske aufgebracht, die ein anorganisches Material enthält, die Opferschicht und die zu strukturierende Schicht werden unter Verwendung der Maske strukturiert, und die Opferschicht und die Maske werden entfernt.

## Beschreibung

Die vorliegende Erfindung betrifft ein Strukturierungsverfahren, insbesondere ein Verfahren zur Strukturierung von plasma- oder trocken-chemisch nur schwer oder nicht ätzbaren Schichten wie beispielsweise Schichten aus Edelmetallen, ferroelektrischen Materialien sowie dielektrischen Materialien mit hoher relativer Dielektrizitätskonstante.

Bei der Entwicklung von hochintegrierten Speicherbausteinen, wie z.B. DRAMs bzw. FRAMs sollte die Zellkapazität bei der fortschreitenden Miniaturisierung beibehalten oder sogar noch verbessert werden. Zur Erreichung dieses Ziels werden immer dünnere dielektrische Schichten und gefaltete Kondensatorelektroden (Trench-Zelle, Stack-Zelle) verwendet. In letzter Zeit werden anstatt des herkömmlichen Siliziumoxids neue Materialien, insbesondere Paraelektrika und Ferroelektrika, zwischen den Kondensatorelektroden einer Speicherzelle verwendet. Beispielsweise kommen Bariumstrontiumtitanat (BST, (Ba,Sr)TiO₃), Bleizirkontitanat (PZT, Pb(Zr,Ti)O₃) bzw. Lanthan-dotiertes Bleizirkontitanat oder Strontiumwismuttantalat (SBT, SrBi₂Ta₂O₉) für die Kondensatoren der Speicherzellen bei DRAMs bzw. FRAMs zum Einsatz.

Dabei werden diese Materialien üblicherweise auf bereits vorhandenen Elektroden (Bodenelektroden) abgeschieden. Die Prozessierung erfolgt unter hohen Temperaturen, so daß die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangsmetalle, insbesondere Platinmetalle (Ru, Rh, Pd, Os, Ir, Pt) und insbesondere Platin selbst, sowie Rhenium als aussichtsreiche Kandidaten, die dotiertes Polysilizium als Elektrodenmaterial in den obengenannten Speicherzellen ersetzen könnten.

Die fortschreitende Miniaturisierung der Bauelemente hat ebenfalls zur Folge, daß Ersatzmaterialien für das heute für die Leiterbahnen verwendete Aluminium erforderlich werden. Dabei sollte das Ersatzmaterial einen geringeren spezifischen Widerstand und eine geringere Elektromigration als Aluminium aufweisen. Als aussichtsreichster Kandidat gilt dabei Kupfer.

Weiterhin erfordert die Entwicklung magnetischer 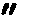 Random Access Memories" (MRAMs) die Integration magnetischer Schichten (z.B. Fe, Co, Ni oder Permalloy) in mikroelektronische Schaltungen.

Um aus den genannten, bisher in der Halbleitertechnologie noch nicht verbreiteten Materialien eine integrierte Schaltung aufbauen zu können, müssen dünne Schichten dieser Materialien strukturiert werden.

Die Strukturierung der bisher verwendeten Materialien erfolgt in der Regel durch sogenannte plasmaunterstützte anisotrope Ätzverfahren. Dabei werden üblicherweise physikalisch-chemische Verfahren angewandt, bei denen Gasgemische aus einem oder mehreren reaktiven Gasen, wie z.B. Sauerstoff, Chlor, Brom, Chlorwasserstoff, Bromwasserstoff bzw. halogenierten Kohlenwasserstoffen und aus Edelgasen (z.B. Ar, He) verwendet werden. Diese Gasgemische werden in der Regel in einem elektromagnetischen Wechselfeld bei geringen Drücken angeregt.

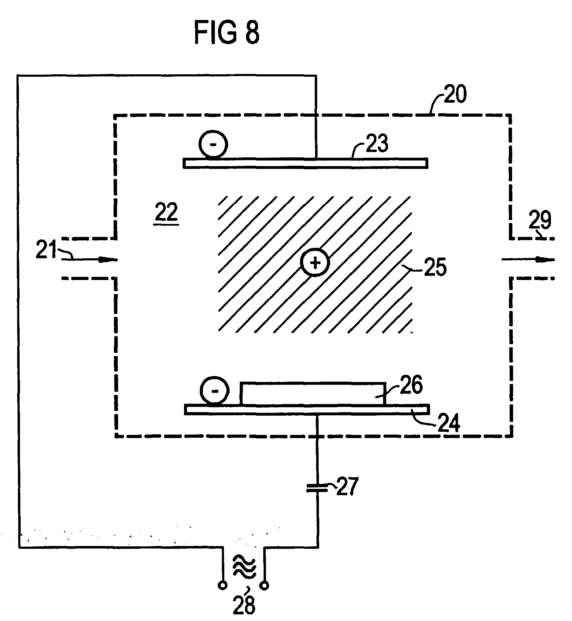

Fig. 8 zeigt die prinzipielle Arbeitsweise einer Ätzkammer, dargestellt am Beispiel eines Parallelplattenreaktors 20. Das Gasgemisch, z.B. Ar und Cl₂, wird über den Gaseinlass 21 der eigentlichen Reaktorkammer 22 zugeführt und durch den Gasauslass 29 wieder abgepumpt. Die untere Platte 24 des Parallelplattenreaktors ist über eine Kapazität 27 mit einer Hochfrequenzquelle 28 verbunden und dient als Substrathalter. Durch das Anlegen eines hochfrequenten elektrischen Wechselfeldes an die obere und die untere Platte 23, 24 des Parallelplattenreaktors wird das Gasgemisch in ein Plasma 25 überführt. Da die Beweglichkeit der Elektronen größer als die der Gaskationen ist, laden sich die obere und die untere Platte 23, 24 gegenüber dem Plasma 25 negativ auf. Daher üben beide Platten 23, 24 auf die positiv geladenen Gaskationen eine hohe Anziehungskraft aus, so daß sie einem permanenten Bombardement durch diese Ionen, z.B. Ar⁺ ausgesetzt sind. Da der Gasdruck zudem niedrig gehalten wird, typischerweise 0.1 - 10 Pa, findet nur eine geringfügige Streuung der Ionen untereinander und an den Neutralteilchen statt, und die Ionen treffen nahezu senkrecht auf die Oberfläche eines Substrats 26, das auf der unteren Platte 24 des Parallelplattenreaktors gehalten ist. Dies erlaubt eine gute Abbildung einer Maske (nicht gezeigt) auf die darunterliegende, zu ätzende Schicht des Substrats 26.

Üblicherweise werden als Maskenmaterialien Photolacke verwendet, da diese durch einen Belichtungsschritt und einen Entwicklungsschritt relativ einfach strukturiert werden können.

Der physikalische Teil der Ätzung wird durch Impuls und kinetische Energie der auftreffenden Ionen (z.B. Cl₂⁺, Ar⁺) bewirkt. Zusätzlich werden dadurch chemische Reaktionen zwischen dem Substrat und den reaktiven Gasteilchen (Ionen, Moleküle, Atome, Radikale) unter Bildung flüchtiger Reaktionsprodukte initiiert oder verstärkt (chemischer Teil der Ätzung). Diese chemischen Reaktionen zwischen den Substratteilchen und den Gasteilchen sind verantwortlich für hohe Ätzselektivitäten des Ätzprozesses.

Leider hat sich herausgestellt, daß die oben genannten, in integrierten Schaltungen neu eingesetzten Materialien zu den chemisch nur schwer oder nicht ätzbaren Materialien gehören, bei denen der Ätzabtrag, auch bei der Verwendung 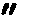 reaktiver" Gase, überwiegend oder fast ausschließlich auf dem physikalischen Anteil der Ätzung beruht.

Wegen der geringen oder fehlenden chemischen Komponente der Ätzung liegt der Ätzabtrag der zu strukturienden Schicht in der selben Größenordnung wie der Ätzabtrag der Maske bzw. der Unterlage (Ätzstoppschicht), d.h. die Ätzselektivität zur Ätzmaske bzw. Unterlage ist im allgemeinen klein (zwischen etwa 0,3 und 3,0). Dies hat zur Folge, daß durch die Erosion von Masken mit geneigten Flanken und die unvermeidliche Facettenbildung (Abschrägung, Taperung) der Masken nur eine geringe Maßhaltigkeit der Strukturierung gewährleistet werden kann. Diese Facettierung beschränkt die bei der Strukturierung kleinsten erzielbaren Strukturgrößen.

Darüber hinaus kann es bei der Strukturierung der zu strukturierenden Schicht zu Redepositionen des Materials der zu strukturierenden Schicht kommen. Diese Redepositionen treten beispielsweise an den Seitenwänden der Lackmaske auf und sie können in nachfolgenden Prozeßschritten häufig nur noch mit großem Aufwand entfernt werden. Da die Redepositionen mit zunehmenden Argonanteil im Ätzgasgemisch zunehmen, ist die Prozeßführung meist auf geringe Argonanteile beispielsweise in einem Chlor-Argon-Plasma beschränkt. Der erhöhte Chloranteil im Ätzgasgemisch führt jedoch wiederum zu einer erhöhten Facettenbildung der Masken.

Weiterhin wird, insbesondere bei einem 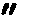 Overetch"-Schritt, die Unterlage stark angeätzt und es kommt zu schwer kontrollierbaren Abschrägungen der Ätzflanken.

Es ist daher die Aufgabe der vorliegenden Erfindung, ein Strukturierungsverfahren bereitzustellen, das die genannten Nachteile der bisherigen Verfahren vermeidet oder mindert.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Strukturierung zumindest einer zu strukturierenden Schicht bereitgestellt, das die folgenden Schritte umfaßt: auf die zu strukturierende Schicht wird eine Opferschicht aufgebracht, auf die Opferschicht wird eine Maske aufgebracht, die ein anorganisches Material enthält, die Opferschicht und die zu strukturierende Schicht werden unter Verwendung der Maske strukturiert, und die Opferschicht und die Maske werden entfernt.

Die Erfindung hat den Vorteil, daß eine Maske, die ein anorganisches Material enthält, im Vergleich zu Photolacken widerstandsfähiger ist, so daß ein chemisches 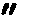 Veraschen" der Maske verhindert wird. Die Maske weist sehr geringe Abtragsraten bei Ätzprozessen mit einem hohen physikalischen Anteil auf. Dies hat insgesamt zur Folge, daß die Selektivität des Ätzprozesses erhöht wird. Durch die geringere Maskenerosion ergibt sich eine höhere Maßhaltigkeit der Strukturierung. Darüber hinaus lassen sich durch das erfindungsgemäße Verfahren auch mit reaktiven Gasen steilere Ätzflanken an der zu strukturienden Schicht erzielen. Ätzflanken mit einem Flankenwinkel von über 85° können erzeugt werden.

Das Material der Opferschicht ist so gewählt, daß es sich im Vergleich zu dem Material der Maske leichter wieder entfernen läßt. Die Erfindung hat somit den Vorteil, daß auch die Maske aufgrund der Opferschicht ohne Schwierigkeiten wieder entfernt werden kann.

Die zu strukturierenden Schichten sind häufig auf einer SiO₂-Unterlage aufgebracht. Topologieerhöhungen, wie sie sonst beispielsweise bei der Entfernung einer SiO₂-Hardmask entstehen, können durch das erfindungsgemäße Verfahren sicher vermieden werden.

Bevorzugt enthält die zu strukturierende Schicht Kupfer, Eisen, Kobalt, Nickel, ein 4d oder 5d Übergangsmetall, insbesondere ein Platinmetall.

Weiterhin ist es bevorzugt, wenn die zu strukturierende Schicht ein ferroelektrisches Material, ein dielektrisches Material hoher relativer Dielektrizitätskonstante (> 20), einen Perowskit oder Vorstufen dieser Materialien enthält. Dabei soll unter einer Vorstufe der genannten Materialien ein Material verstanden werden, das durch eine geeignete Wärmebehandlung (z.B. Tempern), gegebenenfalls unter Zuführung von Sauerstoff, in die genannten Materialien umgewandelt werden kann.

So ist es bevorzugt, wenn die zu strukturierende Schicht Strontiumwismuttantalat (SBT, SrBi₂Ta₂O₉), Strontiumwismutniobattantalat (SBNT, SrBi₂Ta₂₋ₓNbₓO₉, x=0-2) Bleizirkonattitanat (PZT, Pb(Zr,Ti)O₃) oder Derivate sowie Bariumstrontiumtitanat (BST, BaₓSr₁₋ₓTiO₃, x=0-1), Bleilanthantitanat (PLT, (Pb, La)TiO₃), Bleilanthanzirkonattitanat (PLZT, (Pb, La)(Zr, Ti)O₃) oder Derivate enthält.

Weiterhin ist es bevorzugt, wenn die zu strukturierende Schicht Platin, Gold, Silber, Iridium, Palladium, Ruthenium, Rhenium oder deren Oxide enthält.

Gemäß einer bevorzugten Ausführungsform des erfindungsgemäßen Verfahrens enthält die Maske ein Siliziumoxid, insbesondere SiO₂, ein Metall, insbesondere Aluminium, Titan oder Wolfram, ein Metallnitrid, bevorzugt ein Titannitrid, insbesondere TiNₓ 0.8 < x < 1.2, oder ein Metallsilizid.

Bevorzugt enthält die Opferschicht ein organisches Material, insbesondere Polyimid, Polysilizium, zumindest eine Spin-on-Glasschicht oder Aluminium.

Weiterhin ist es bevorzugt, wenn während der Trockenätzung der zu strukturienden Schicht ein reaktiver Stoff, insbesondere ein reaktives Gas, vorgesehen ist.

Vorteilhafterweise ist das reaktive Gas aus einer Gruppe ausgewählt, die aus den Gasen Sauerstoff (O₂), gasförmige Fluorverbindungen, Chlor (Cl₂), Halogenwasserstoffe, Halogenkohlenwasserstoffe oder einer Mischung dieser Gase besteht.

Weiterhin ist es bevorzugt, wenn während der Trockenätzung der zu strukturienden Schicht ein Edelgas, insbesondere Argon, vorgesehen ist.

Bevorzugt wird zum Trockenätzen der zu strukturienden Schicht ein Plasmaätzverfahren verwendet.

Gemäß einer bevorzugten Ausführungsform des erfindungsgemäßen Verfahrens werden die Opferschicht und die Maske durch eine Abhebetechnik entfernt. Die Opferschicht kann aber auch verascht werden, wobei das Maskenmaterial dann durch eine 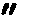 Scrubber"-Reinigung entfernt wird.

Vorteilhafterweise wird das Material der Maske durch eine Phototechnik strukturiert. Gemäß einer bevorzugten Ausführungsform des erfindungsgemäßen Verfahrens wird die Maske unter Verwendung einer Lackmaske erst vorstrukturiert und, nach Entfernung der Lackmaske, vollständig strukturiert. Dies hat den Vorteil, daß beim Entfernen der Lackmaske die Opferschicht noch nicht freiliegt, so daß eine vorzeitige Schädigung der Opferschicht vermieden wird.

Die Erfindung wird nachfolgend anhand von Figuren der Zeichnung näher dargestellt. ES zeigen:
Fig. 1 bis 7 eine schematische Darstellung des erfindungsgemäßen Verfahrens, und
Fig. 8 eine schematische Darstellung einer Ätzkammer in Form eines Parallelplattenreaktors.

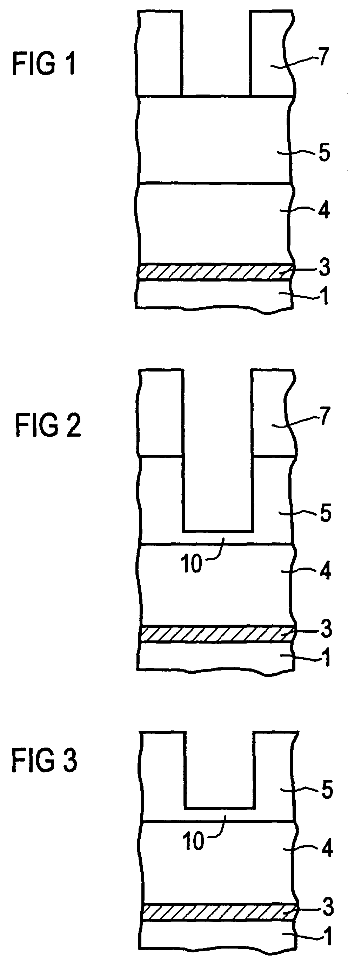

Die Figuren 1 bis 7 zeigen eine schematische Darstellung des erfindungsgemäßen Verfahrens. Auf einem geeignetem Substrat 1, z.B. einem SiO₂-Substrat, wird eine Platinschicht 3 als zu strukturierende Schicht beispielsweise durch Sputtern aufgebracht. Auf der Platinschicht 3 wird eine Polyimidschicht 4 als Opferschicht gebildet. Auf die Polyimidschicht 4 wird eine SiO₂-Schicht 5 beispielsweise durch einen TEOS- oder Silan-Prozeß aufgebracht, welche später als SiO₂-Hardmask 6 für die Strukturierung der Polyimidschicht 4 und der Platinschicht 3 dient. Auf die SiO₂-Schicht 5 wird eine Lackschicht aufgebracht, welche durch Belichtungs- und einen Entwicklungsschritt als Lackmaske 7 für die Strukturierung der SiO₂-Schicht 5 dient. Die sich daraus ergebende Struktur ist in Fig. 1 gezeigt.

Anschließend wird die SiO₂-Schicht 5 plasmachemisch anisotrop geätzt, um als Maske 6 für die anschließende Strukturierung der Opferschicht 4 und der Platinschicht 3 dienen zu können. Als Ätzgase können dabei beispielsweise CHF₃/CF₄ oder C₄F₈/CO verwendet werden.

Allerdings wird bei diesem Schritt die SiO₂-Schicht 5 noch nicht vollständig strukturiert. Die plasmachemische Ätzung wird so durchgeführt, daß Opferschicht 4 an jeder Stelle zumindest noch mit einem dünnen Bereich 10 der SiO₂-Schicht 5 bedeckt ist. Die Dicke des dünnen Bereichs 10 der SiO₂-Schicht 5 beträgt vorteilhafterweise 25% der Schichtdicke der SiO₂-Schicht 5. Die sich daraus ergebende Struktur ist in Fig. 2 gezeigt.

Anschließend wird die Lackmaske 7 durch einen naßchemischen Prozeß oder durch Veraschen entfernt, wobei die Polyimidschicht 3 durch die dünnen Bereiche 10 der SiO₂-Schicht geschützt ist. Die sich daraus ergebende Struktur ist in Fig. 3 gezeigt.

Als Alternative kann die Lackmaske 7 aber auch erst nach der Strukturierung der Platinschicht 3 entfernt werden. In diesem Fall verstärkt die verbliebene Lacksmaske 7 die als Maske dienende SiO₂-Schicht 5.

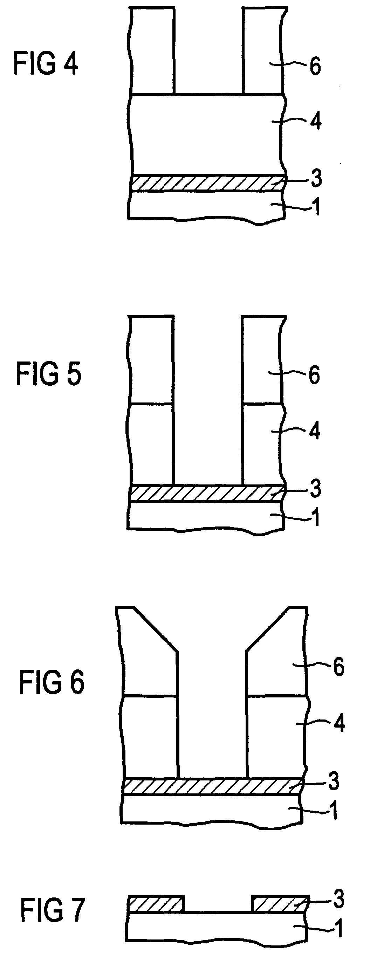

Es folgt eine anisotrope Durchätzung der restlichen SiO₂-Schicht 5, so daß die SiO₂-Hardmask 6 entsteht. Mit diesem Prozeßschritt wird die Polyimidschicht 4 am Boden der Strukturöffnungen freigelegt. Für die Folgeprozeßschritte stehen noch etwa 75% der Dicke der SiO₂-Schicht 5 für die SiO₂-Hardmask 6 zur Verfügung. Die sich daraus ergebende Struktur ist in Fig. 4 gezeigt.

Anschließend wird die Polyimidschicht 4 plasmachemisch anisotrop geätzt, so daß der zu entfernende Bereich der Platinschicht 3 freigelegt wird. Als Ätzgas wird hierfür eine Mischung von Sauerstoff und Argon verwendet. Die sich daraus ergebende Struktur ist in Fig. 5 gezeigt.

Nachfolgend wird ein reaktives Ionenätzen (RIE, Reactive Ion Etching) durchgeführt, um die Platinschicht 3 einem chemischphysikalischen Trockenätzen zu unterziehen. Als Ätzgas wird dabei beispielsweise Argon mit einem Zusatz von Chlor Cl₂ und Sauerstoff O₂ verwendet. Anstatt des reaktiven Ionenätzens können auch andere Plasmaätzverfahren wie beispielsweise das magnetfeldunterstützte reaktive Ionenätzen (MERIE, Magnetically Enhanced RIE), das ECR-Ätzen (ECR, Electron Cyclotron Resonance) oder induktiv gekoppelte Plasmaätzverfahren (ICP, TCP) eingesetzt werden. Die sich daraus ergebende Struktur ist in Fig. 6 gezeigt.

Da als Ätzgas Argon mit einem Zusatz von Chlor Cl₂ eingesetzt werden kann, ohne daß es zu einer zu starken Facettierung der Maske 6 kommt, können Redepositionen von Platin an den Seitenwänden der Polyimidschicht 4 vermieden werden. Durch die geringere Maskenerosion ergibt sich eine höhere Maßhaltigkeit der Strukturierung. Darüber hinaus lassen sich somit steilere Ätzflanken an der zu strukturienden Schicht erzielen. Ätzflanken mit einem Flankenwinkel von über 85° können erzeugt werden. Somit können mit dem erfindungsgemäßen Verfahren nahezu vertikale Profile bei gleichzeitiger Vermeidung von Redepositionen erzeugt werden.

Anschließend wird auch die noch verbliebene Sandwichmaske aus Polyimidschicht 4 und SiO₂-Maske 6 durch eine Abhebetechnik entfernt. Die sich daraus ergebende Struktur ist in Fig. 7 gezeigt.

Die Erfindung hat somit den Vorteil, daß die SiO₂-Maske 6 aufgrund der Opferschicht 4 leicht wieder entfernt werden kann. Topologieerhöhungen, wie sie sonst bei der Entfernung einer SiO₂-Hardmask entstehen, können durch das erfindungsgemäße Verfahren sicher vermieden werden.

## Patentansprüche

1. Verfahren zur Strukturierung zumindest einer zu strukturierenden Schicht mit den Schritten:
auf die zu strukturierende Schicht wird eine Opferschicht aufgebracht,
auf die Opferschicht wird eine Maske aufgebracht, die ein anorganisches Material enthält,
die Opferschicht und die zu strukturierende Schicht werden unter Verwendung der Maske strukturiert, und
die Opferschicht und die Maske werden entfernt.

2. Verfahren nach Anspruch 1, dadurch gekennzeichnet, daß die zu strukturierende Schicht Kupfer, Eisen, Kobalt, Nickel, ein 4d oder 5d Übergangsmetall, insbesondere ein Platinmetall, enthält.

3. Verfahren nach Anspruch 1, dadurch gekennzeichnet, daß die zu strukturierende Schicht ein ferroelektrisches Material, ein dielektrisches Material hoher relativer Dielektrizitätskonstante, einen Perowskit oder Vorstufen dieser Materialien enthält.

4. Verfahren nach Anspruch 3, dadurch gekennzeichnet, daß die zu strukturierende Schicht Strontiumwismuttantalat (SBT, SrBi₂Ta₂O₉), Strontiumwismutniobattantalat (SBNT, SrBi₂Ta₂₋ₓNbₓO₉, x=0-2), Bleizirkonattitanat (PZT, Pb(Zr,Ti)O₃) oder Derivate oder Bariumstrontiumtitanat (BST, BaₓSr₁₋ₓTiO₃, x=0-1), Bleilanthantitanat (PLT, (Pb, La)TiO₃), Bleilanthanzirkonattitanat (PLZT, (Pb, La)(Zr, Ti)O₃) oder Derivate enthält.

5. Verfahren nach Anspruch 2, dadurch gekennzeichnet, daß die zu strukturierende Schicht Platin, Gold, Silber, Iridium, Palladium, Ruthenium, Rhenium oder deren Oxide enthält.

6. Verfahren nach einem der vorherstehenden Ansprüche, dadurch gekennzeichnet, daß die Maske ein Siliziumoxid, insbesondere SiO₂, ein Metall, insbesondere Aluminium, Titan oder Wolfram, ein Metallnitrid, bevorzugt ein Titannitrid, insbesondere TiNₓ 0.8 < x < 1.2, oder ein Metallsilizid enthält.

7. Verfahren nach einem der vorherstehenden Ansprüche, dadurch gekennzeichnet, daß die Opferschicht ein organisches Material, insbesonder Polyimid, Polysilizium, zumindest eine Spin-on-Glasschicht oder Aluminium enthält.

8. Verfahren nach einem der vorherstehenden Ansprüche, dadurch gekennzeichnet, daß während der Trockenätzung der zu strukturienden Schicht ein reaktiver Stoff, insbesondere ein reaktives Gas, vorgesehen ist.

9. Verfahren nach Anspruch 8, dadurch gekennzeichnet, daß das reaktive Gas aus einer Gruppe ausgewählt ist, die aus den Gasen Sauerstoff (O₂), Stickstoff (N₂), Wasserstoff (H₂), gasförmige Fluorverbindungen, Halogenwasserstoffe, Halogenkohlenwasserstoffe, Chlor (Cl₂) oder einer Mischung dieser Gase besteht.

10. Verfahren nach einem der vorherstehenden Ansprüche, dadurch gekennzeichnet, daß während der Trockenätzung der zu strukturienden Schicht ein Edelgas, insbesondere Argon, vorgesehen ist.

11. Verfahren nach einem der vorherstehenden Ansprüche, dadurch gekennzeichnet, daß zum Trockenätzen ein Plasmaätzverfahren verwendet wird.

12. Verfahren nach einem der vorherstehenden Ansprüche, dadurch gekennzeichnet, daß die Opferschicht und die Maske durch eine Abhebetechnik entfernt werden.

13. Verfahren nach einem der Ansprüche 1 bis 11, dadurch gekennzeichnet, daß die Opferschicht verascht und das Maskenmaterial durch eine 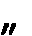 Scrubber"-Reinigung entfernt wird.

14. Verfahren nach einem der vorherstehenden Ansprüche, dadurch gekennzeichnet, daß das Material der Maske durch eine Phototechnik strukturiert wird.

15. Verfahren nach Anspruch 14, dadurch gekennzeichnet, daß die Maske unter Verwendung einer Lackmaske erst vorstrukturiert und, nach Entfernung der Lackmaske, vollständig strukturiert wird.
